# EUROPÄISCHE PATENTANMELDUNG

(11) **EP 1 528 479 A2**
(43) Veröffentlichungstag der Anmeldung: **04.05.2005**
(21) Anmeldenummer: 04018689.2
(22) Anmeldetag: 06.08.2004
(51) Int. Cl.: G06F 13/40, H04L 7/00

(54) **Verfahren und Vorrichtung zur Erzeugung einer internen Zeitbasis für eine Diagnosefunktion für einen Endstufenbaustein**

(30) Priorität: 23.09.2003 DE 10344004
(71) Anmelder: ROBERT BOSCH GMBH, 70442 Stuttgart (DE)
(72) Erfinder: Windmueller, Andreas-Martin, 71679 Asperg (DE)

(57) **Zusammenfassung**

Vorrichtung zur Erzeugung einer internen Zeitbasis für eine Diagnosefunktion (107) für einen Endstufenbaustein (105), wobei der Endstufenbaustein (105) mit einer seriellen Schnittstelle (104) verbindbar ist, welche ihrerseits eine Taktleitung (TL) enthält und über diese serielle Schnittstelle (104) Daten von und/oder zu dem Endstufenbaustein entsprechend einem Zeittakt auf der Taktleitung (TL) übertragen werden, dadurch gekennzeichnet, dass erste Mittel (106) vorgesehen sind, die aus dem auf der Taktleitung (TL) der seriellen Schnittstelle (104) übertragenen Zeittakt die interne Zeitbasis für den Endstufenbaustein (105) ermitteln.

## Beschreibung

### Stand der Technik

Die Erfindung geht aus von einer Vorrichtung und einem Verfahren zur Erzeugung einer internen Zeitbasis für eine Diagnosefunktion für einen Endstufenbaustein sowie entsprechendem Endstufenbaustein gemäß den Oberbegriffen der unabhängigen Ansprüche.

Endstufenbausteine benötigen eine interne Zeitbasis, um Fehlererkennungsmechanismen für Diagnosefunktionen auf dem Endstufenbaustein darzustellen. Diese Zeitbasis wird beispielsweise durch eine auf dem Chip integrierte Oszillatorschaltung realisiert. Nachteil dieser Schaltungen zur Erzeugung der internen Zeitbasis ist eine hohe Ungenauigkeit. Dabei schwankt der spezifizierte Bereich teilweise um bis zu Faktor 4, beispielsweise von 60 bis 240 µs.

Des Weiteren sind Endstufenbausteine über eine serielle Schnittstelle zur Datenübertragung, beispielsweise um den Baustein zu konfigurieren oder um Diagnoseinformationen auszulesen, mit einem den Endstufenbaustein ansprechenden Steuergerät oder einer Steuereinheit verbunden, wie dies in der DE 197 33 748 C2 dargestellt ist.

Aufgabe der Erfindung ist es nun, bei der Erzeugung der internen Zeitbasis für eine Diagnosefunktion auf dem Endstufenbaustein und daraus abgeleiteter Zeiten eine höhere Genauigkeit zu erzielen.

### Vorteile der Erfindung

Diese Aufgabe wird gelöst durch eine Vorrichtung und ein Verfahren zur Erzeugung einer internen Zeitbasis für eine Diagnosefunktion für einen Endstufenbaustein wobei der Endstufenbaustein mit einer seriellen Schnittstelle verbindbar ist. welche ihrerseits eine Taktleitung enthält und über diese serielle Schnittstelle Daten von und/oder zu dem Endstufenbaustein entsprechend einem Zeittakt auf der Taktleitung übertragen werden, wobei vorteilhafter Weise Mittel vorgesehen sind, die aus dem auf der Taktleitung der seriellen Schnittstelle übertragenen Zeittakt die interne Zeitbasis für den Endstufenbaustein ermitteln. Es wird somit die Taktleitung einer seriellen Schnittstelle als Zeitbasis für Diagnosefunktionen auf einem Endstufenbaustein genutzt. D. h. wenn typintern, also Endstufenintern, Zeiten für Diagnosezwecke abgeleitet werden müssen, wird dies durch Umsetzung der Takte einer seriellen Schnittstelle realisiert.

Zweckmäßiger Weise sind zweite Mittel vorgesehen, die aus dem Zeittakt eine Filterzeit oder Entprellzeit für Fehlererkennungsmechanismen für die Diagnosefunktion ermitteln.

Dabei wird zweckmäßiger Weise ein elektronischer Zähler vorgesehen, der die einzelnen Zeittakte erfasst und die gezählten Zeittakte die Grundlage für die interne Zeitbasis des Endstufenbausteins bilden.

Dabei ist bei der Vorrichtung in einem Mikroprozessor, der über die serielle Schnittstelle mit dem Endstufenbaustein verbindbar ist, ein Zeittaktvorgabemittel enthalten, insbesondere ein Quarzoszillator, der zweckmäßiger Weise eine relativ genaue Frequenz bzw. einen relativ genauen Zeittakt für die Taktleitung der seriellen Schnittstelle und somit für die interne Zeitbasis des Endstufenbausteins liefert. Als serielle Schnittstelle wird dabei zweckmäßiger Weise ein SPI (Serial Peripheral Interface) oder ein Micro-Second-Bus wie beispielsweise in oben genannter DE 197 33 748 C2 dargestellt, eingesetzt.

Zweckmäßiger Weise liegt dabei der Zeittakt der Taktleitung der seriellen Schnittstelle immer am Endstufenbaustein an, und zwar, sobald dieser in Betrieb ist also Energie aufnimmt.

Dabei wird vorteilhafter Weise ein Zellzyklus entsprechend der vorgegebenen Filter- oder Entprellzeit abhängig vom Zeittakt der Taktleitung der seriellen Schnittstelle vorgegeben.

Durch diese Erfindung erfolgt vorteilhafter Weise eine Kosteneinsparung, da eine feste interne Zeitbasis. insbesondere eine Oszillatorschaltung entfallen kann.

Weitere Vorteile und vorteilhafte Ausgestaltungen ergeben sich aus der Beschreibung sowie den Merkmalen der Ansprüche.

### Zeichnung

Im Nachfolgenden wird die Erfindung anhand der in der Zeichnung dargestellten Figuren näher erläutert. Dabei zeigt

Figur 1 eine erfindungsgemäße Vorrichtung, bei der eine Prozessoreinheit und ein Endstufenbaustein durch eine serielle Schnittstelle verbunden sind.

Figur 2 zeigt ein Zustandsdiagramm zu Diagnosefunktionen auf der Endstufe, bei der eine Zeitableitung aus der erfindungsgemäßen Zeitbasis, insbesondere zur Darstellung von Filterzeiten erfolgt.

### Beschreibung der Ausführungsbeispiele

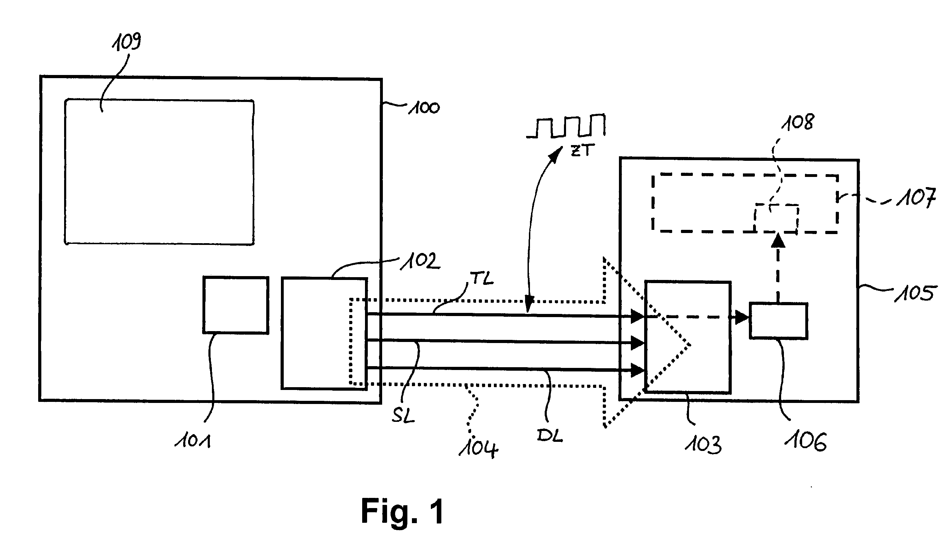

Kern der Erfindung ist es, die Taktleitung einer seriellen Schnittstelle als Zeitbasis zu nutzen. Wenn typintern, also endstufenintern, Zeiten für Diagnosezwecke, also insbesondere Fehlererkennungsmechanismen abgeleitet werden müssen, kann dies erfindungsgemäß durch Erfassen insbesondere Zählen der Takte einer seriellen Schnittstelle wie SPI oder Micro-Second-Bus realisiert werden. Da die Taktfrequenz einer seriellen Schnittstelle von einem Mikroprozessor, also einer Prozessoreinheit bereitgestellt wird, welcher wiederum seinen Takt von einer relativ genauen Zeitbasis, insbesondere einem Quarzoszillator gewinnt, ist der Zeittakt bzw. die Frequenz des selben und damit auch die damit abgeleitete Zeitbasis des Endstufenbausteins relativ genau, insbesondere in einem Vergleich mit einer üblicherweise verwendeten Oszillatorschaltung, beispielsweise ein VCO (Voltage Controlled Oszillator), welcher dadurch erfindungsgemäß weggelassen werden kann. Dazu zeigt Figur 1 eine Prozessoreinheit respektive Mikroprozessor oder auch Steuereinheit 100. Eine solche Steuereinheit findet insbesondere Anwendung zur Steuerung von Betriebsabläufen in einem Fahrzeug, wie beispielsweise im Rahmen der Motorsteuerung, der Bremsensteuerung oder auch der Getriebesteuerung usw. Solche Steuereinheiten oder Prozessoreinheiten sind aber auch in der Prozessautomatisierung, im Werkzeugmaschinenbereich oder auch in anderen Industrieanwendungen einsetzbar. Über eine serielle Schnittstelle 104, beispielsweise SPI oder Micro-Second-Bus, ist diese Prozessoreinheit 100 mit einem Endstufenbaustein, insbesondere einer Leistungsendstufe 105 verbunden. Dabei ist ein erster Schnittstellenbaustein 102 in der Prozessoreinheit 100 und ein zweiter Schnittstellenbaustein 103 in der Endstufe 105 vorgesehen. Die Schnittstelle 104 selber enthält eine Datenleitung DL, eine Synchronisationsleitung SL und eine Taktleitung TL, auf welcher ein Zeittakt TZT übertragen wird. Wesentlich und entscheidend für die Erfindung ist das Vorhandensein respektive der Einsatz einer Taktleitung TL im Rahmen der seriellen Schnittstelle 104, so dass erfindungsgemäß jede Schnittstelle, die diese Voraussetzung erfüllt, erfindungsgemäß einsetzbar und damit an dieser Stelle als offenbart angesehen werden kann. Die Prozessoreinheit 100 enthält eine Verarbeitungseinheit 109 und ein Zeittaktvorgabemittel 101 mit einem relativ genauen Zeittakt, insbesondere einem Quarzoszillator. Erfindungsgemäß ist der Takt des Zeittaktvorgabemittels 101 genauer als eine übliche interne Zeitbasis des Endstufenbausteins, welche erfindungsgemäß weggelassen werden kann.

Vielmehr enthält der Endstufenbaustein 105 ein erstes Mittel 106, insbesondere einen elektronischen Zähler, der die Takte ZT der Taktleitung TL der seriellen Schnittstelle 104 erfasst und damit die Grundlage zur Erzeugung der internen Zeitbasis des Endstufenbausteins 105 bildet. Außer einem Zähler kann auch ein Zeitauswertemittel oder ein Frequenzauswertemittel zur Takterfassung vorgesehen sein. Die Diagnosefunktionalität ist symbolisch in einem Diagnoseblock 107 dargestellt, wobei zweite Mittel 108 in der Endstufe insbesondere als Teil des Diagnoseblocks 107 enthalten sind. Diese zweiten Mittel 108 sind dazu vorgesehen, aus dem Zeittakt bzw. dem von dem ersten Mittel 106 ausgegebenen Signal eine Filterzeit FT für die Diagnosefunktionalität, also hier symbolisch Block 107 zu ermitteln. Dies erfolgt durch Verarbeitung der Takte respektive des erfassten Signals beispielsweise durch Faktorisierung, Division oder vergleichbaren Umsetzungen.

Der zugrundeliegende Takt kann dabei beispielsweise von einer SPI als serielle Schnittstelle 104 abgeleitet werden oder auch von einem Micro-Second-Bus. Bei einem Micro-Second-Bus ist vorgesehen, ein serielles Schieberegister. das Prozessoreinheitintern vom Zeittaktvorgabemittel 101 angesteuert wird, einzusetzen, um eine Parallel-Seriell-Wandlung mehrerer paralleler Pins auf die serielle Schnittstelle durchzuführen. Dabei wird der Takt für das Schieberegister im Schnittstellenbaustein 102 so hoch gewählt, dass eine bestimmte Anzahl an Bits in sehr kurzer Zeit übertragen werden können, wie beispielsweise 16Bit in einer Mikrosekunde, daher der Name Micro-Second-Bus. In der Endstufe 105 respektive im Schnittstellenbaustein 103 findet dann wieder eine Seriell-/Parallel-Wandlung statt, wodurch mit dem gewandelten Signal eine entsprechende Anzahl paralleler Endstufentransistoren bei einer Leistungsendstufe parallel angesteuert werden können. Wie bei SPI ist auch hierbei auf der Taktleitung TL der seriellen Schnittstelle 104 ein Zeittakt ZT zur Datenübertragung vorgesehen. Dabei hat ein SPI-Takt typischerweise 1MHz, also beispielsweise eine Taktperiode von 1µs, wohingegen ein Micro-Second-Bus-Takt beispielsweise im Bereich von 16MHz liegt und damit eine Taktperiode von 62,5ns repräsentiert. Dabei ist nun erfindungsgemäß Voraussetzung, dass der Takt im Betrieb des Endstufenbausteins permanent an diesem anliegt. Dies kann microcontrollerseitig, also auf Seiten der Prozessoreinheit 100, so eingestellt werden, dass der Takt nach Power up und Initialisierung des Steuergeräts, also der Prozessoreinheit 100 und somit bei einer Motorsteuerung noch vor dem Motorstart und bis zur Beendigung der Energieaufnahme, also beispielsweise bei einer Motorsteuerung bis Ende des Nachlaufs aktiv ist. D. h. der Takt der Taktleitung TL muss während der gesamten Phase, in der im Endstufenbaustein 105 Energie zugeführt wird, also die Endstufe in Betrieb ist, anliegen.

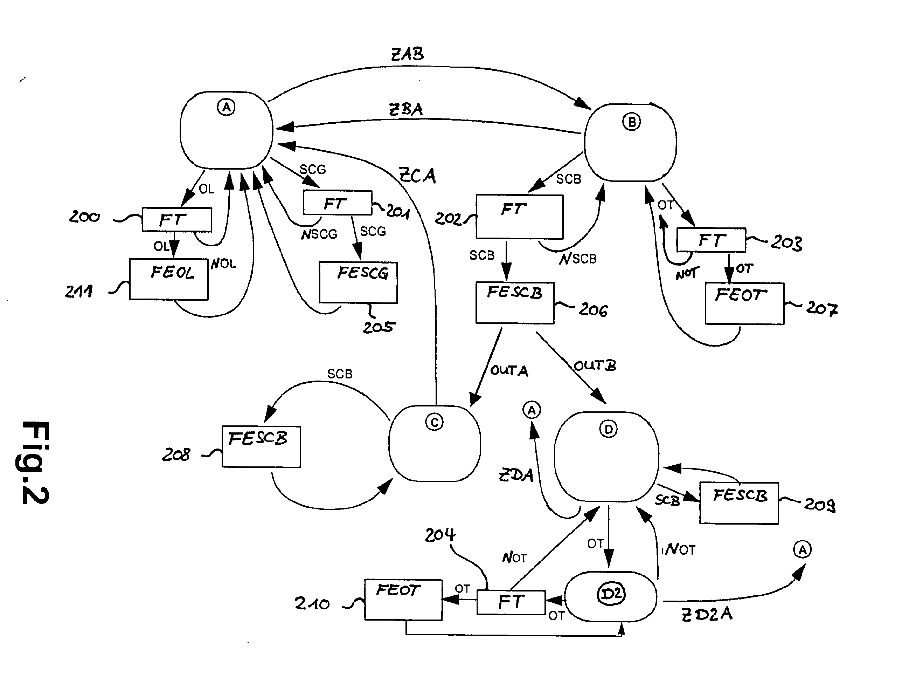

Erfindungsgemäß wird nun die durch die Taktleitung gewonnene Zeitbasis für Diagnosefunktionen, insbesondere zur Ermittlung einer Diagnosefilterzeit oder Entprellzeit genutzt. Dies ist im Zustandsdiagramm von Figur 2 dargestellt. Bei Auftreten von Fehlern wie beispielsweise Kurzschluss nach Masse, Kurzschluss nach Batteriespannung oder Lastabfall des entsprechenden Steuergerätesteckeranschlusses wird ein Fehler erst nach Ablauf einer sogenannten Filter- oder Entprellzeit weiter gemeldet, um Falschmeldungen durch kurze interne Störungen zu vermeiden. Auch bei weiteren Funktionen wie der Überwachung einer Spannungsschwelle, insbesondere der Versorgungsspannung wie beispielsweise 5V werden Filterzeiten verwendet. D. h. es wird dabei geprüft, ob ein bestimmter Fehler für eine bestimmte Zeit vorliegt oder nicht.

Mit solchen Fehlererkennungsmechanismen werden folgende Fehler erkannt:
Kurzschluss des Endstufenausgangs bzw. der Last gegen Masse SCG, Kurzschluss des Endstufenausgangs bzw. der Last gegen Batteriespannung SCB, Lastabfall bzw. Leitungsunterbrechung zwischen Endstufenausgang und Last oder Last- und Batteriespannung OL wenn der Strom im eingeschalteten Zustand zu hoch ist. z. B. durch Nebenschlüsse im Kabelbaum, die Endstufe zu hohe Temperatur hat, OT. oder die Versorgungsspannung des Endstufenbausteins zu niedrig respektive zu hoch ist. Ein Fehler wird erst nach Ablauf einer sogenannten Entprellzeit oder Filterzeit FT weiterQemeldet und es erfolgt beispielsweise ein Eintrag in ein Fehlerregister oder Diagnoseregister. Erst wenn der Fehler länger vorhanden ist als die Filterzeit wird ein Fehlereintrag vorgenommen, und der Fehler kann ausgelesen werden.

Im Endstufenbaustein werden die Filterzeiten beispielsweise durch Taktzähler realisiert. Um z. B. eine Filterzeit in der Größenordnung von 50µs zu realisieren, müsste bei einer SPI-Schnittstelle mit einer µs-Takt-Periode auch 50 gezählt werden. Es kann dabei also ein 6Bit-Zähler Anwendung finden. Beim Micro-Second-Bus mit einer Taktperiode von 62,5ns muss dann auf 800 gezählt werden, wobei ein 10Bit-Zähler Anwendung finden kann.

In Figur 2 nun sind verschiedene Zustände des Endstufenbausteins A bis D und D2 dargestellt, die im Wesentlichen durch den Pegel des Signals auf der Datenleitung DL, also High oder Low als Eingangspin und gleichzeitig der Beschaltung des entsprechenden Endstufenausgangs Ein oder Aus charakterisiert werden. Im Zustand A ist der Eingangspin High und der Ausgang Aus. In Zustand B ist der Eingangspin Low und der Ausgang Ein. Es erfolgt also ein Zustandsübergang ZAB von A nach B, in dem der Eingangspin von High auf Low schaltet. Die Leistungsendstufe wird somit durch den Eingangspin kontrolliert. Umgekehrt erfolgt ein Übergang von Zustand B in Zustand A ZBA durch einen Wechsel des Eingangspins von Low auf High. Tritt nun im Zustand A ein Lastabfall OL auf, wird dieser im Block 200 aufgrund einer Filterzeit FT verifiziert. Liegt der Fehler OL bei Ablauf der Filterzeit FT nicht mehr an, wird auf keinen Lastabfallfehler No OL NOL entschieden und in Zustand A zurückgekehrt. Ansonsten, also bei Anliegen des Fehlers OL nach Ablauf der Filterzeit FT erfolgt im Block 211 ein Fehlereintrag FEOL dieses Fehlers. Tritt im Zustand A ein Kurzschluss nach Masse auf, SCG. wird auch hier im Block 201 anhand der Filterzeit FT geprüft, ob der Fehler Bestand hat. Bleibt der Fehler nicht bestehen, wird auf kein Fehler NSCG entschieden und zu Zustand A zurückgekehrt. Ansonsten erfolgt im Block 205 ein Fehlereintrag FESCG dieses Fehlers.

In Zustand B, charakterisiert durch Eingangspin Low und Ausgang Ein, tritt beispielsweise ein Übertemperaturfehler OT auf. Im Block 203 wird anhand der Filterzeit FT dieser Übertemperaturfehler geprüft und entsprechend bei anhaltendem Fehler durch Fehlereintrag FEOT in Block 207 fixiert. Hat der Übertemperaturfehler OT. beispielsweise registriert durch Schwellwertüberschreitung, keinen Bestand im Rahmen der Filterzeit FT, wird auch kein Fehler NOT erkannt und zu Zustand B zurückgekehrt. Wird in Zustand B des Endstufenbausteins ein Fehler SCB, also Kurzschluss nach Batterie erkannt, erfolgt im Block 202 anhand der Filterzeit FT ebenfalls die Prüfung, ob dieser Bestand hat oder nicht. Hat der Fehler keinen Bestand, wird wieder auf kein Fehler No SCB NSCB entschieden und es wird in Zustand B zurückgekehrt. Bleibt der Fehler bestehen SCB, erfolgt im Block 206 ein Fehlereintrag FESCB.

Ausgehend von diesem Fehlereintrag FESCB im Block 206 wird dann beispielsweise in zwei Zustände C oder D verzweigt. Dies kann beispielsweise abhängig von bestimmten Ausgängen der Endstufe Out A oder Out B erfolgen, d. h. je nachdem welcher Ausgang der Endstufe eingeschaltet ist oder nicht. Gleichermaßen kann die Verzweigung erfolgen, ob eine Strombegrenzung eingeschaltet ist oder nicht, also beispielsweise in Zustand D, wenn die Strombegrenzung Ein ist und in Zustand C, wenn diese nicht Ein ist. In Zustand D ist der Eingangspin Low und der Ausgang Ein. Ein Übergang zurück in den Zustand A erfolgt über ZDA durch eine Umschaltung des Eingangspins von Low auf High. Tritt in Zustand D ein Fehler SCB auf, erfolgt im Block 209 der Fehlereintrag FESCB und die Rückkehr in Zustand D.

Tritt ein Übertemperaturfehler OT auf, wird beispielsweise in einen Zustand D2 verzweigt, bei dem ebenfalls der Eingangspin auf Low ist, der Ausgang aber ausgeschaltet. Tritt in diesem Zustand D2 der Fehler OT nicht mehr auf, wird beispielsweise mit NOT zurück in Zustand D verzweigt. Gleichermaßen wird aus Zustand D2 über ZD2A durch Umschaltung des Eingangspins von Low auf High in den Zustand A verzweigt. Tritt im Zustand D2 der Übertemperaturfehler OT weiterhin auf, wird anhand der Filterzeit FT in Block 204 verifiziert, ob eine Registrierung des Fehlers erfolgen wird. Besteht der Fehler OT nach Ablauf der Filterzeit nicht weiter. wird zurück zu Zustand D mit NOT verzweigt. Im anderen Fall, also bei Bestehen des Fehlers OT über die Filterzeit FT hinaus bzw. bei Ablauf der Filterzeit, erfolgt wieder der Fehlereintrag FEOT in Block 210 und der Rücksprung in Zustand D2. Bei einer Verzweigung aus Block 206 in Zustand C kann auch. beispielsweise bei Auftritt des Fehlers SCB ein Fehlereintrag FESCB in Block 208 erfolgen ohne Filterzeitbestimmung. Ein Übergang von Zustand C in Zustand A erfolgt über ZCA durch Umschaltung des Eingangspins von Low auf High, wobei der Zustand C durch Eingangspin Low und Ausgang Aus charakterisiert ist.

In diesem Beispiel sind nun alle Filterzeiten FT gleichartig gewählt. Es ist aber erfindungsgemäß ebenso denkbar, abhängig vom jeweiligen Fehler unterschiedliche Filterzeiten vorzusehen. Mit diesen Filterzeiten erfolgt somit eine Entprellung bezüglich der Fehlereinträge, wobei die Filterzeit erfindungsgemäß, wie bereits beschrieben, aus dem Taktsignal ZT der Taktleitung TL der seriellen Schnittstelle abgeleitet wird und damit vorteilhafter Weise auf eine explizite interne Zeitbasis, wie beispielsweise einen VCO, also eine Oszillatorschaltung, verzichtet werden kann.

## Patentansprüche

1. Vorrichtung zur Erzeugung einer internen Zeitbasis für eine Diagnosefunktion (107) für einen Endstufenbaustein (105), wobei der Endstufenbaustein (105) mit einer seriellen Schnittstelle (104) verbindbar ist, welche ihrerseits eine Taktleitung (TL) enthält und über diese serielle Schnittstelle (104) Daten von und/oder zu dem Endstufenbaustein entsprechend einem Zeittakt auf der Taktleitung (TL) übertragen werden, **dadurch gekennzeichnet, dass** erste Mittel (106) vorgesehen sind, die aus dem auf der Taktleitung (TL) der seriellen Schnittstelle (104) übertragenen Zeittakt die interne Zeitbasis für den Endstufenbaustein (105) ermitteln.

2. Vorrichtung nach Anspruch 1, **dadurch gekennzeichnet, dass** zweite Mittel (108) vorgesehen sind die aus dem Zeittakt eine Filterzeit (FT) für die Diagnosefunktion (107) ermitteln.

3. Vorrichtung nach Anspruch 1, **dadurch gekennzeichnet, dass** als erstes Mittel (106) ein elektronischer Zähler vorgesehen ist, der die einzelnen Zeittakte erfasst.

4. Vorrichtung nach Anspruch 1, **dadurch gekennzeichnet, dass** Zeittaktvorgabemittel (101) in einem Mikroprozessor (100) vorgesehen sind die den Zeittakt der Taktleitung (TL) vorgeben und der Mikroprozessor (100) über die serielle Schnittstelle (104) mit dem Endstufenbaustein (105) verbunden ist.

5. Vorrichtung nach Anspruch 1, **dadurch gekennzeichnet, dass** als serielle Schnittstelle ein SPI eingesetzt wird.

6. Vorrichtung nach Anspruch 1, **dadurch gekennzeichnet, dass** als serielle Schnittstelle ein us-Bus eingesetzt wird.

7. Endstufenbaustein (105) mit einer Vorrichtung zur Erzeugung einer internen Zeitbasis für eine Diagnosefunktion (107) für den Endstufenbaustein (105) wobei der Endstufenbaustein mit einer seriellen Schnittstelle (104) verbindbar ist, welche ihrerseits eine Taktleilung (TL) enthält und über diese serielle Schnittstelle (104) Daten von und/oder zu dem Endstufenbaustein entsprechend einem Zeittakt auf der Taktleitung (TL) übertragen werden, **dadurch gekennzeichnet, dass** in dem Endstufenbaustein (105) erste Mittel (106) vorgesehen sind, die aus dem auf der Taktleitung (TL) der seriellen Schnittstelle (104) übertragenen Zeittakt die interne Zeitbasis für den Endstufenbaustein (105) ermitteln.

8. Endstufenbaustein nach Anspruch 7, **dadurch gekennzeichnet, dass** zweite Mittel (108) vorgesehen sind die aus dem Zeittakt eine Filterzeit (FT) für die Diagnosefunktion (107) ermitteln.

9. Endstufenbaustein nach Anspruch 7, **dadurch gekennzeichnet, dass** als erstes Mittel (106) ein elektronischer Zähler vorgesehen ist, der die einzelnen Zeittakte erfasst.

10. Verfahren zur Erzeugung einer internen Zeitbasis für eine Diagnosefunktion (107) für einen Endstufenbaustein (105), wobei der Endstufenbaustein mit einer seriellen Schnittstelle (104) verbindbar ist, welche ihrerseits eine Taktleitung (TL) enthält und über diese serielle Schnittstelle (104) Daten von und/oder zu dem Endstufenbaustein (105) entsprechend einem Zeittakt auf der Taktleitung (TL) übertragen werden, **dadurch gekennzeichnet, dass** aus dem auf der Taktleitung (TL) der seriellen Schnittstelle (104) übertragenen Zeittakt die interne Zeitbasis für den Endstufenbaustein (105) ermittelt wird.

11. Verfahren nach Anspruch 10, **dadurch gekennzeichnet, dass** aus dem Zeittakt eine Filterzeit (FT) für die Diagnosefunktion (107) ermittelt wird.

12. Verfahren nach Anspruch 10, **dadurch gekennzeichnet, dass** der Zeittakt bei Energieaufnahme des Endstufenbausteins immer am diesem anliegt.

13. Verfahren nach Anspruch 11, **dadurch gekennzeichnet, dass** ein Zählzyklus entsprechend der vorgegebenen Filterzeit abhängig vom Zeittakt der Taktleitung der seriellen Schnittstelle vorgegeben wird.
